# FASCICULE DE BREVET EUROPEEN

(11) **EP 0 734 805 B1**
(45) Date de publication et mention de la délivrance du brevet: **16.06.1999**
(21) Numéro de dépôt: 96420093.5
(22) Date de dépôt: 20.03.1996
(51) Int. Cl.: B23H 7/08, C23C 14/56

(54) **Procédé et dispositif pour la fabrication de fil électrode pour étincelage érosif**
Vorrichtung und Verfahren zum Herstellen von Drahtelektroden zum funkenerosiven Schneiden
Method and apparatus for making wire electrodes for electric discharge machining

(30) Priorité: 27.03.1995 FR 9503756
(43) Date de publication de la demande: 02.10.1996
(73) Titulaire: THERMOCOMPACT, 74370 Metz Tessy (FR)
(72) Inventeur: Lacourcelle, Louis, 34700 Saint Jean de la Blaquiere (FR)
(74) Mandataire: Poncet, Jean-François

(56) Documents cités:
- EP-A- 0 185 492
- EP-A- 0 312 674
- US-A- 4 977 303
- PATENT ABSTRACTS OF JAPAN vol. 012, no. 223 (C-507), 24 Juin 1988 & JP-A-63 018072 (FURUKAWA ELECTRIC CO LTD:THE), 25 Janvier 1988,

## Description

La présente invention concerne les électrodes en forme de fil que l'on utilise dans l'usinage de pièces métalliques par électroérosion.

Dans un tel usinage, décrit par exemple dans le document FR-A-2 418 699, une électrode en forme de fil est entraînée selon une trajectoire à proximité d'une pièce métallique à usiner. Un générateur électrique produit une différence de potentiel entre la pièce à usiner et le fil métallique formant l'électrode. Un étincelage se produit dans la zone d'usinage comprise entre le fil formant l'électrode et la pièce métallique, et érode progressivement la pièce et le fil.

On a pu constater que la rapidité de l'usinage par électroérosion dépend notamment de la nature des matériaux constituant l'électrode en forme de fil. Ainsi, une amélioration de la rapidité d'usinage a pu être constatée lors de l'utilisation d'un fil électrode dont la couche superficielle est un alliage diffusé de cuivre et de zinc. Par exemple, les documents EP-A-0 185 492 et EP-A-0 312 674 enseignent, pour obtenir un fil électrode procurant une plus grande vitesse d'usinage par électroérosion, de fabriquer le fil selon un procédé comprenant au moins les deux étapes successives suivantes : déposer une couche d'épaisseur appropriée sur la périphérie d'un fil en acier cuivré, par dépôt électrolytique ; puis chauffer le fil ainsi revêtu de la couche de zinc pour diffuser le zinc et le cuivre l'un dans l'autre et réaliser ainsi une couche superficielle d'alliage diffusé de cuivre et de zinc. Le document US-A-4 977 303 enseigne un procédé similaire dans lequel on oxyde simultanément la couche superficielle du fil.

Bien que ces procédés procurent des résultats améliorés, ils présentent encore des inconvénients importants, et notamment : les procédés en deux étapes successives de dépôt de zinc puis de diffusion thermique nécessitent un processus relativement long, qui limite la vitesse de production du fil ; le dépôt de zinc par dépôt électrolytique nécessite des dispositifs relativement complexes qui, bien qu'ils soient parfaitement maîtrisés en général, sont relativement encombrants et nécessitent une surveillance constante ; la vitesse de production du fil est limitée par les contraintes de densité de courant lors du dépôt électrolytique ; de plus, les vitesses de diffusion des métaux ne sont pas très rapides, de sorte qu'il est difficile de concilier à la fois une vitesse suffisante de production et une diffusion suffisante des métaux ; ce défaut est encore plus accentué lorsque l'on veut obtenir un fil électrode dont la couche superficielle est en alliage de cuivre et de zinc à proportion de zinc importante sur une profondeur importante, supérieure à 10 microns.

On connaît par ailleurs, dans JP-A-63 018072, un procédé de fabrication de fil électrode par dépôt de zinc sur un fil de laiton dans un four contenant de la vapeur de zinc à environ 600°C.

Le problème proposé par la présente invention est d'améliorer encore les performances d'électroérosion en réalisant et en utilisant un fil à couche d'alliage diffusé de cuivre et de zinc de profondeur augmentée, tout en augmentant la rapidité de fabrication du fil afin d'en réduire le coût de fabrication.

L'invention vise également à simplifier le procédé de fabrication du fil électrode, pour le rendre adaptable éventuellement sur une machine d'électroérosion, le fil étant fabriqué en continu en amont de la zone d'électroérosion et à la vitesse de défilement appropriée pour l'usinage par électroérosion.

Dans la description et les revendications, l'expression "alliage diffusé de cuivre et de zinc" désigne un alliage métallique contenant du cuivre et du zinc qui a été obtenu par diffusion du zinc dans le cuivre ou l'alliage de cuivre.

Pour atteindre ces objets ainsi que d'autres, la présente invention prévoit un procédé de fabrication de fils électrodes pour électroérosion dans lequel on apporte du zinc sur au moins un fil d'entrée en cuivre ou alliage de cuivre ou en tout autre matériau recouvert de cuivre ou d'alliage de cuivre et on réalise une couche superficielle d'alliage diffusé de cuivre et de zinc par diffusion thermique du zinc dans l'épaisseur de cuivre ou d'alliage de cuivre du fil d'entrée ; selon l'invention, le procédé comprend une étape au cours de laquelle on fait passer au moins une fois le fil d'entrée dans un four contenant de la vapeur de zinc sous atmosphère inerte à une température supérieure à environ 600°C tout en échauffant le fil par apport d'énergie calorifique complémentaire pour l'amener rapidement dans le four à une température favorisant la diffusion du zinc dans l'épaisseur du fil d'entrée et inférieure à la température de fusion du fil d'entrée. Ladite étape réalise ainsi par elle-même, après refroidissement à la sortie du four, un fil à couche superficielle d'alliage diffusé de cuivre et de zinc.

Selon un mode de réalisation avantageux, l'apport d'énergie calorifique complémentaire est réalisé par effet Joule, en faisant passer un courant électrique approprié dans la portion de fil traversant le four. On peut ainsi contrôler et maîtriser la température atteinte par le fil dans le four. On peut éventuellement poursuivre l'échauffement du fil en sortie du four pendant une durée supplémentaire permettant d'augmenter la diffusion du zinc. On peut aussi, en alternative ou en complément, préchauffer le fil d'entrée à une température appropriée pour éviter la condensation de zinc sur le fil à son entrée dans le four.

On a pu constater que le fil ainsi réalisé présente une surface extérieure légèrement rugueuse, mais beaucoup moins rugueuse qu'un fil réalisé par le procédé traditionnel de dépôt d'une couche de zinc suivi d'une diffusion par échauffement. Ainsi, la surface extérieure de fil obtenue selon l'invention est directement utilisable pour l'électroérosion, présentant une légère rugosité juste appropriée pour l'étincelage érosif, sans nécessiter de traitement mécanique de surface excepté un calibrage.

Par le fait que les machines d'usinage par électroérosion nécessitent d'utiliser des fils électrodes dont le diamètre extérieur est parfaitement défini, il est généralement nécessaire d'effectuer une dernière opération de calibrage mécanique. Cette opération de calibrage mécanique peut avantageusement réduire le diamètre du fil selon une proportion faible telle que le rapport des diamètres de fil après et avant calibrage soit supérieur à 0,9. Cela permet d'augmenter encore la profondeur relative de la couche superficielle d'alliage diffusé, profondeur qui n'est pas réduite sensiblement lorsque le calibrage est faible.

L'invention prévoit un dispositif pour la mise en oeuvre de ce procédé, permettant la production de fils électrodes pour électroérosion à couche superficielle d'alliage diffusé de cuivre et de zinc réalisée sur un ou plusieurs fils d'entrée en cuivre ou alliage de cuivre ou en tout autre matériau recouvert de cuivre ou d'alliage de cuivre. Selon l'invention, le dispositif comprend :
- un four comportant une paroi périphérique généralement étanche entourant une cavité intérieure, avec au moins une entrée étanche et au moins une sortie étanche et des moyens pour déplacer en continu le ou les fils d'entrée une ou plusieurs fois à travers la cavité du four en les faisant pénétrer par la ou les entrées et ressortir par la ou les sorties,
- des moyens pour maintenir dans la cavité du four une température supérieure à 600°C environ,
- des moyens pour générer dans la cavité du four une vapeur de zinc sous atmosphère inerte,
- des moyens pour effectuer dans la ou les portions de fil traversant le four un apport d'énergie calorifique complémentaire pour les amener rapidement à une température favorisant la diffusion de zinc dans l'épaisseur du ou des fils d'entrée.

Selon un mode de réalisation avantageux, les moyens pour effectuer un apport d'énergie calorifique complémentaire comprennent des moyens pour faire passer un courant électrique contrôlé dans la portion de fil traversant la cavité du four, permettant ainsi d'échauffer le fil par effet Joule.

Un fil électrode obtenu par un procédé selon l'invention comprend de préférence une couche superficielle d'alliage diffusé de cuivre et de zinc, dont l'épaisseur est supérieure à 10 microns.

Le fil peut comprendre une âme en cuivre ou alliage de cuivre. En alternative, le fil peut comprendre une âme formée d'un noyau central recouvert d'une couche supérieure de cuivre ou d'alliage de cuivre elle-même recouverte de ladite couche superficielle d'alliage diffusé de zinc et de cuivre ou d'alliage de cuivre.

D'autres objets, caractéristiques et avantages de la présente invention ressortiront de la description suivante de modes de réalisation particuliers, faite en relation avec les figures jointes, parmi lesquelles :
- la figure 1 est une représentation schématique d'un dispositif de production d'un fil électrode pour électroérosion selon un mode de réalisation de la présente invention ; et
- la figure 2 est une vue en perspective illustrant schématiquement un tronçon de fil électrode pour électroérosion selon l'invention.

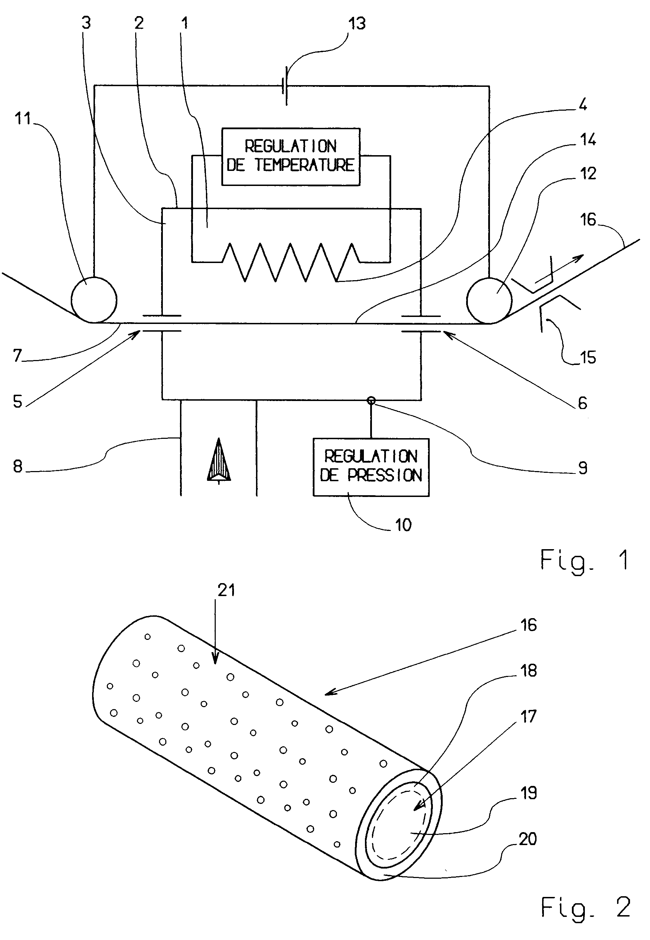

Dans le mode de réalisation illustré sur la figure 1, un dispositif selon l'invention pour la production d'un fil électrode pour électroérosion comprend un four 1 comportant une paroi périphérique 2 généralement étanche entourant une cavité 3 intérieure. Des moyens de chauffage régulé 4 permettent de maintenir dans la cavité 3 intérieure du four 1 une température supérieure à 600°C environ, par exemple comprise entre environ 600°C et 800°C. La paroi périphérique 2 du four 1 comprend une entrée étanche 5 et une sortie étanche 6 adaptées pour permettre le passage d'un fil d'entrée 7 destiné à constituer en sortie le fil électrode 16 pour électroérosion. Des moyens de transfert de fil, non représentés sur la figure, permettent de tenir le fil 7 et de le déplacer en continu une ou plusieurs fois à travers la cavité 3 du four 1 entre l'entrée 5 et la sortie 6. Dans le mode de réalisation illustré sur la figure 1, l'entrée 5 et la sortie 6 sont opposées l'une à l'autre. En alternative, l'entrée 5 et la sortie 6 peuvent être côte à côte selon le même côté du four, ou confondues.

Le four 1 comprend en outre des moyens pour générer dans la cavité 3 du four 1 une vapeur de zinc sous atmosphère inerte. Pour cela, une trémie 8 de chargement en zinc permet d'introduire du zinc métallique à l'intérieur du four 1, en quantité appropriée pour produire une vapeur saturée en zinc dans la cavité 3. L'atmosphère inerte peut être constituée par exemple d'un gaz neutre tel que l'argon ou l'azote, dont la pression est régulée par un capteur de pression 9 associé à un régulateur de pression 10 pouvant être de type connu.

Au voisinage de l'entrée 5 du four 1, le fil d'entrée 7 touche un contact d'entrée 11. De même, au voisinage de la sortie 6 du four 1, le fil 16 touche un contact de sortie 12. Les contacts 11 et 12 sont connectés aux deux bornes respectives d'un générateur de courant électrique 13, permettant de faire passer dans le fil, notamment dans la portion 14 de fil traversant le four 1, un courant électrique assurant son échauffement par effet Joule. Le courant peut avantageusement être réglé pour amener au rouge la portion 14 du fil 7 qui traverse le four 1. Ainsi, on réalise des moyens électriques permettant d'effectuer un apport d'énergie calorifique complémentaire dans la portion 14 de fil traversant la cavité 3 du four 1.

Selon un mode de réalisation, les contacts 11 et 12 peuvent être à proximité immédiate respectivement de l'entrée 5 et de la sortie 6 du four 1, de sorte que l'échauffement du fil est limité à la seule portion 14 traversant la cavité 3 du four 1.

Si on le désire, le contact d'entrée 11 peut être disposé à l'extérieur du four 1, et à l'écart de l'entrée 5, pour produire un échauffement préliminaire du fil d'entrée 7 avant sa pénétration dans le four 1. Le préchauffage du fil d'entrée 7 peut avantageusement amener le fil à une température appropriée pour éviter la condensation de zinc sur le fil à son entrée dans le four 1. On peut ainsi profiter pleinement de la rapidité de diffusion de zinc en phase vapeur dans l'épaisseur du fil d'entrée 7, sans que cette diffusion soit perturbée par une couche superficielle de zinc condensé.

De même, le contact de sortie 12 peut être placé à l'extérieur du four 1 et à l'écart de la sortie 6, pour produire sur le fil de sortie 16 un échauffement complémentaire permettant d'augmenter la diffusion du zinc dans l'épaisseur du fil.

En aval, le dispositif peut comprendre une filière de calibrage 15, assurant une mise à dimension mécanique du fil 16 en sortie du four 1.

Ainsi, lors de la fabrication d'un fil électrode pour électroérosion au moyen d'un dispositif illustré sur la figure 1, on fait passer au moins une fois le fil d'entrée 7 dans le four 1 contenant de la vapeur de zinc sous atmosphère inerte à une température supérieure à environ 600°C, tout en échauffant le fil par apport d'énergie calorifique complémentaire assuré par le courant électrique produit par le générateur 13, amenant rapidement le fil à une température favorisant la diffusion du zinc dans l'épaisseur du fil mais inférieure à la température de fusion du fil d'entrée 7. Le fil d'entrée 7 comprend une couche supérieure de cuivre ou d'alliage de cuivre. Après passage dans le four 1, le fil comprend une couche superficielle d'alliage diffusé de cuivre et de zinc.

Dans le cas où le contact de sortie 12 est à l'écart de la sortie 6 du four 1, on poursuit l'échauffement du fil pendant une durée supplémentaire permettant de compléter la diffusion du zinc.

De bons résultats sont obtenus si, lors de son passage dans le four 1, le fil est chauffé au rouge.

La température à l'intérieur du four 1 peut avantageusement être choisie de manière à permettre, selon la vitesse de défilement du fil, d'amener le fil qui le traverse à une température comprise entre 700°C et 800°C. De bons résultats sont obtenus pour une température de fil voisine de 750°C, qui permet un traitement relativement rapide, tout en évitant de trop s'approcher de la température de fusion du cuivre.

Le procédé peut avantageusement comprendre un étape préalable de dégraissage et/ou décapage du fil d'entrée 7, par méthode chimique ou électrochimique, avant son passage dans le four 1.

Le procédé est compatible avec le traitement d'un fil d'entrée 7 présentant un diamètre sensiblement égal au diamètre final désiré du fil électrode. En effet, la vitesse d'apport et de diffusion du zinc, qui est très rapide avec le procédé de l'invention, est compatible avec le débit nécessaire du fil 16 en sortie lors de sa production. Le traitement d'un fil d'entrée 7 présentant sensiblement sa dimension de sortie permet d'augmenter encore la profondeur de la couche superficielle d'alliage diffusé de cuivre et de zinc. L'opération éventuelle de calibrage en sortie doit alors de préférence réduire le diamètre du fil selon une proportion faible telle que le rapport des diamètres de fil après et avant calibrage soit supérieur à 0,9 environ.

Mais le procédé est également compatible avec une ou plusieurs étapes de tréfilage en sortie.

Une amélioration de la rapidité de traitement peut être encore obtenue lorsque les vapeurs et gaz contenus dans le four 1 sont à une pression supérieure à la pression atmosphérique.

De préférence, la vapeur de zinc est saturée ou sursaturée dans le four 1.

On a représenté schématiquement, sur la figure 2, la structure d'un fil électrode 16 obtenu par le procédé selon l'invention.

Ce fil électrode comprend une âme 17, qui peut être entièrement homogène en cuivre ou alliage de cuivre, ou qui peut comporter une couche supérieure 18 en cuivre ou alliage de cuivre entourant un noyau central 19 en un autre matériau, par exemple en acier ou en aluminium ou même en un matériau non métallique. L'âme 17 est recouverte d'une couche superficielle 20 épaisse d'alliage diffusé à base de cuivre et de zinc, provenant des vapeurs de zinc contenues dans le four 1 se déposant et se combinant par diffusion avec le cuivre ou l'alliage de cuivre de la couche supérieure 18 de l'âme 17. Selon l'invention, on peut aisément produire une couche superficielle 20 d'alliage diffusé de cuivre et de zinc à haute teneur en zinc et dont l'épaisseur peut être supérieure à 40 microns. Une augmentation d'épaisseur est aisément obtenue en allongeant le four ou en faisant passer le fil plusieurs fois dans le four.

En sortie du four 1, et avant toute opération de calibrage, la couche superficielle 20 présente une surface périphérique 21 légèrement granuleuse, comme illustré schématiquement sur la figure 2, de qualité déjà satisfaisante pour une utilisation comme électrode d'électroérosion. Le calibrage par la filière 15 réduit quelque peu l'état granuleux de la surface périphérique 21, sans toutefois qu'il soit nécessaire de réduire cet état granuleux selon une proportion importante, de sorte qu'il est possible d'utiliser un calibrage léger, réduisant en très faible proportion le diamètre du fil et l'épaisseur de la couche superficielle 20.

Grâce à la rapidité du procédé et à la simplicité du dispositif permettant de le mettre en oeuvre, la couche superficielle 20 peut être réalisée en continu à la vitesse de défilement du fil lors de l'usinage par électroérosion. Il est ainsi possible de placer le dispositif en entrée d'une machine d'électroérosion, de façon à traiter le fil d'entrée 7 en continu en amont de la zone d'usinage par électroérosion.

La présente invention n'est pas limitée aux modes de réalisation qui ont été explicitement décrits, mais elle en inclut les diverses variantes et généralisations contenues dans le domaine des revendications ci-après.

## Revendications

1. Procédé de fabrication de fils électrodes pour électroérosion, dans lequel on apporte du zinc, sur au moins un fil d'entrée (7) en cuivre ou alliage de cuivre ou en tout autre matériau recouvert de cuivre ou d'alliage de cuivre, et on réalise une couche superficielle (20) d'alliage diffusé de cuivre et de zinc par diffusion thermique du zinc dans l'épaisseur de cuivre ou d'alliage de cuivre du fil d'entrée (7), caractérisé en ce qu'il comprend une étape au cours de laquelle on fait passer au moins une fois le fil d'entrée (7) dans un four (1) contenant de la vapeur de zinc sous atmosphère inerte à une température supérieure à environ 600°C tout en échauffant le fil (7) par apport d'énergie calorifique complémentaire pour l'amener rapidement dans le four (1) à une température favorisant la diffusion du zinc dans l'épaisseur du fil d'entrée (7) et inférieure à la température de fusion du fil d'entrée (7), ladite étape réalisant par elle-même, après refroidissement à la sortie du four (1), ledit fil (16) à couche superficielle (20) d'alliage diffusé de cuivre et de zinc.

2. Procédé selon la revendication 1, caractérisé en ce que l'apport d'énergie calorifique complémentaire est réalisé par effet Joule, en faisant passer un courant électrique approprié dans la portion (14) de fil traversant le four (1).

3. Procédé selon l'une des revendications 1 ou 2, caractérisé en ce que, à sa sortie du four (1) contenant la vapeur de zinc en atmosphère inerte, on poursuit l'échauffement du fil de sortie (16) pendant une durée supplémentaire pour augmenter la diffusion du zinc.

4. Procédé selon l'une quelconque des revendications 1 à 3, caractérisé en ce que, avant sa pénétration dans le four (1), on préchauffe le fil d'entrée (7) à température appropriée pour éviter la condensation de zinc sur le fil à son entrée dans le four (1).

5. Procédé selon l'une quelconque des revendications 1 à 4, caractérisé en ce que, lors de son passage dans le four (1) le fil (7) est chauffé au rouge.

6. Procédé selon l'une quelconque des revendications 1 à 5, caractérisé en ce que la température du four (1) est choisie de manière à permettre, selon la vitesse de défilement du fil, d'amener le fil qui le traverse à une température comprise entre 700°C et 800°C, avantageusement voisine de 750°C.

7. Procédé selon l'une quelconque des revendications 1 à 6, caractérisé en ce qu'il comprend une étape préalable de dégraissage et/ou de décapage du fil d'entrée (7) par méthode chimique ou électrochimique, avant son passage dans le four (1).

8. Procédé selon l'une quelconque des revendications 1 à 7, caractérisé en ce que le fil d'entrée (7) présente un diamètre sensiblement égal au diamètre final désiré du fil électrode (16) en sortie.

9. Procédé selon la revendication 8, caractérisé en ce que, après passage dans le four (1) le fil de sortie (16) subit une opération de calibrage mécanique réduisant son diamètre selon une proportion faible.

10. Procédé selon l'une quelconque des revendication 1 à 9, caractérisé en ce que les vapeurs et gaz contenus dans le four (1) sont à une pression supérieure à la pression atmosphérique.

11. Dispositif pour la production d'un fil électrode (16) pour électroérosion à couche superficielle (20) d'alliage diffusé de cuivre et de zinc réalisée sur un ou plusieurs fils d'entrée (7) en cuivre ou alliage de cuivre ou en tout autre matériau recouvert de cuivre ou d'alliage de cuivre, caractérisé en ce qu'il comprend :
- un four (1) comportant une paroi périphérique (2) généralement étanche entourant une cavité (3) intérieure, avec au moins une entrée étanche (5) et au moins une sortie étanche (6) et des moyens pour déplacer en continu le ou les fils d'entrée (7) une ou plusieurs fois à travers la cavité (3) du four (1) en les faisant pénétrer par la ou les entrées (5) et ressortir par la ou les sorties (6),
- des moyens (4) pour maintenir dans la cavité (3) du four (1) une température supérieure à environ 600°C,
- des moyens (8) pour générer dans la cavité (3) du four (1) une vapeur de zinc sous atmosphère inerte,
- des moyens (11, 12, 13) pour effectuer dans la ou les portions (14) de fil traversant le four (1) un apport d'énergie calorifique complémentaire pour les amener rapidement à une température favorisant la diffusion de zinc dans l'épaisseur du ou des fils d'entrée (7).

12. Dispositif selon la revendication 11, caractérisé en ce que les moyens (11, 12, 13) pour effectuer un apport d'énergie calorifique complémentaire comprennent des moyens pour faire passer un courant électrique contrôlé dans la portion (14) de fil traversant la cavité (3) du four (1).

13. Dispositif selon l'une des revendications 11 ou 12, caractérisé en ce qu'il est placé en entrée d'une machine d'électroérosion, de façon à traiter le fil d'entrée (7) en continu en amont de la zone d'usinage par électroérosion.

## Claims

1. Method of manufacturing spark erosion electrode wires wherein zinc is applied to at least one entry wire (7) of copper or copper alloy or any other material covered with copper or copper alloy, and a surface layer (20) of diffused copper-zinc alloy is produced by thermal diffusion of zinc into the thickness of the copper or copper alloy of the entry wire (7), characterized in that it comprises a step during which the entry wire (7) is passed at least once through a furnace (1) containing zinc vapor in an inert atmosphere at a temperature greater than approximately 600°C while the wire (7) is heated by additional heat input so that in the furnace (1) its temperature rapidly rises to a value promoting diffusion of zinc into the thickness of the entry wire (7) but less than the melting point of the entry wire (7), said step producing directly, after cooling at the exit from the furnace (1), said wire (16) with a surface layer (20) of diffused copper-zinc alloy.

2. Method according to claim 1, characterized in that the additional heat input is obtained by the Joule effect by passing an appropriate electrical current through the portion (14) of the wire passing through the furnace (1).

3. Method according to claim 1 or claim 2, characterized in that, at the exit from the furnace (1) containing zinc vapor in an inert atmosphere, the wire (16) is heated continuously for a further time period to increase the diffusion of zinc.

4. Method according to any one of claims 1 to 3, characterized in that, before it enters the furnace (1), the entry wire (7) is preheated to an appropriate temperature to prevent the condensation of zinc on the wire when it enters the furnace (1).

5. Method according to any one of claims 1 to 4, characterized in that when it passes through the furnace (1) the wire (7) is heated to red heat.

6. Method according to any one of claims 1 to 5, characterized in that the temperature of the furnace (1) is chosen, in accordance with the wire feed rate, to enable heating of the wire passing through it to a temperature between 700°C and 800°C, advantageously close to 750°C.

7. Method according to any one of claims 1 to 6, characterized in that it comprises a preliminary step of degreasing and/or cleaning the entry wire (7) by chemical or electrochemical means before it enters the furnace (1).

8. Method according to any one of claims 1 to 7, characterized in that the entry wire (7) has a diameter substantially equal to a required final diameter of the electrode wire (16) at the exit.

9. Method according to claim 8, characterized in that, after passing through the furnace (1) the exit wire (16) is subject to a mechanical sizing operation reducing its diameter by a relatively small amount.

10. Method according to any one of claims 1 to 9, characterized in that the vapors and gas contained in the furnace (1) are at a pressure greater than atmospheric pressure.

11. Device for making spark erosion electrode wire (16) having a surface layer (20) of diffused copper-zinc alloy by processing one or more entry wires (7) of copper or copper alloy or any other material covered with copper or copper alloy, characterized in that it comprises :
- a furnace (1) having a generally sealed peripheral wall (2) around an interior cavity (3) with at least one sealed entry (5) and at least one sealed exit (6) and means for continuously moving the entry wire or wires (7) at least once through the cavity (3) of the furnace (1) which they enter via the entry or entries (5) and leave via the exit or exits (6),
- means (4) for maintaining a temperature exceeding approximately 600°C in the cavity (3) of the furnace (1),
- means (8) for generating zinc vapor in an inert atmosphere in the cavity (3) of the furnace (1),
- means (11, 12, 13) for additional input of heat to the portion or portions (14) of wire passing through the furnace (1) to heat them rapidly to a temperature promoting the diffusion of zinc into the thickness of the entry wire or wires (7).

12. Device according to claim 11, characterized in that the additional heat input means (11, 12, 13) comprise means for passing a controlled electrical current through the portion (14) of wire passing through the cavity (3) of the furnace (1).

13. Device according to claim 11 or claim 12, characterized in that it is at the entry of a spark erosion machine so as to process the entry wire (7) continuously on the input side of the spark erosion machining area.

## Patentansprüche

1. Verfahren zum Herstellen von Drahtelektroden für eine Funkenerosion, bei welchem Zink auf wenigstens einen Einführungsdraht (7) aus Kupfer oder einer Kupferlegierung oder einem ganz anderen, mit Kupfer oder einer Kupferlegierung bedeckten Material zugeführt und eine Oberflächenschicht (20) aus einer diffundierten Kupfer- und Zinklegierung durch eine thermische Diffusion von Zink in die Dickenabmessung des Kupfers oder der Kupferlegierung des Einführungsdrahtes (7) realisiert wird, dadurch gekennzeichnet, daß es aus einer Stufe besteht, in deren Verlauf der Einführungsdraht (7) wenigstens einmal in einen Ofen (1) eingeführt wird, welcher Zinkdampf unter einer inerten Atmosphäre bei einer höheren Temperatur von etwa 600°C enthält, um den Draht (7) in dem Ofen (1) durch Zuführung einer komplementären Wärmeenergie rasch auf eine Temperatur zu überführen, welche die Diffusion von Zink in die Dickenabmessung des Einführungsdrahtes (7) favorisiert und niedriger ist als die Schmelztemperatur des Einführungsdrahtes (7), wobei sich diese Stufe von selbst realisiert, worauf der Draht (16) nach der Abkühlung bei dem Austritt aus dem Ofen (1) eine Oberflächenschicht (20) aus einer diffundierten Kupfer- und Zinklegierung hat.

2. Verfahren nach Anspruch 1, dadurch gekennzeichnet, daß die Zuführung der komplementären Wärmeenergie durch einen Joule-Effekt realisiert wird, indem ein passender elektrischer Strom durch den Abschnitt (14) des Drahtes hindurchgeleitet wird, der durch den Ofen (1) hindurchgeht.

3. Verfahren nach einem der Ansprüche 1 oder 2, dadurch gekennzeichnet, daß bei seinem Austritt aus dem Ofen (1), welcher den Zinkdampf unter einer inerten Atmosphäre enthält, die Aufwärmung des Ausführungsdrahtes (16) während einer ergänzenden Dauer durchgeführt wird, um die Diffusion von Zink zu erhöhen.

4. Verfahren nach einem der Ansprüche 1 bis 3, dadurch gekennzeichnet, daß vor seinem Eindringen in den Ofen (1) der Einführungsdraht (7) auf eine passende Temperatur vorgewärmt wird, um die Kondensation von Zink auf dem Draht bei seinem Eintritt in den Ofen (1) zu vermeiden.

5. Verfahren nach einem der Ansprüche 1 bis 4, dadurch gekennzeichnet, daß bei seinem Durchgang in dem Ofen (1) der Draht (7) zum Glühen gebracht wird.

6. Verfahren nach einem der Ansprüche 1 bis 5, dadurch gekennzeichnet, daß die Temperatur des Ofens (1) derart gewählt wird, daß in Abhängigkeit von der Geschwindigkeit des Abspulens des Drahtes dem ihn durchquerenden Draht die Zuführung einer Temperatur erlaubt wird, die zwischen 700°C und 800°C, bevorzugt etwa 750°C, liegt.

7. Verfahren nach einem der Ansprüche 1 bis 6, dadurch gekennzeichnet, daß es eine vorgehende Stufe der Entfettung und/oder der Beizung des Einführungsdrahtes (7) durch ein chemisches oder elektrochemisches Verfahren vor seinem Durchgang durch den Ofen (1) umfaßt.

8. Verfahren nach einem der Ansprüche 1 bis 7, dadurch gekennzeichnet, daß der Einführungsdraht (7) einen Durchmesser im wesentlichen gleich dem finalen Durchmesser aufweist, der für die Drahtelektrode (16) beim Austritt gewünscht ist.

9. Verfahren nach Anspruch 8, dadurch gekennzeichnet, daß nach dem Durchgang durch den Ofen (1) der Ausführungsdraht (16) eine mechanische Kalibrierungsbearbeitung seines Durchmessers zu einem geringfügigen Anteil erfährt.

10. Verfahren nach einem der Ansprüche 1 bis 9, dadurch gekennzeichnet, daß die in dem Ofen (1) enthaltenen Dämpfe und Gase unter einem Druck höher als der atmosphärische Druck stehen.

11. Vorrichtung zum Herstellen einer Drahtelektrode (16) für die Funkenerosion mit einer Oberflächenschicht (20) aus einer diffundierten Kupfer- und Zinklegierung, die auf einem oder mehreren Einführungsdrähten (7) aus Kupfer oder einer Kupferlegierung oder aus ganz anderen Materialien bedeckt mit Kupfer oder einer Kupferlegierung realisiert ist, dadurch gekennzeichnet, daß sie besteht aus:
- einem Ofen (1), der eine generell dichte Umfangswand (2) aufweist, die einen inneren Hohlraum (3) umgibt, mit wenigstens einem dichten Einlaß (5) und wenigstens einem dichten Auslaß (6) und mit Mitteln für eine kontinuierliche Ortsveränderung des oder der Einführungsdrähte (7) einmal oder mehrere Male quer über den Hohlraum (3) des Ofens (1), indem sie durch den oder die Einlässe (5) zum Eindringen und über den oder die Auslässe (6) zum Verlassen gebracht werden,
- Mitteln (4) zur Aufrechterhaltung einer höheren Temperatur von etwa 600°C in dem Hohlraum (3) des Ofens (1),
- Mitteln (8) zur Erzeugung eines Zinkdampfes unter einer inerten Atmosphäre in dem Hohlraum (3) des Ofens (1),
- Mitteln (11, 12, 13) zum Bewirken einer komplementären Wärmeenergiezufuhr in dem oder in den den Ofen (1) durchquerenden Abschnitten (14) des Drahtes, um sie rasch auf eine Temperatur zu überführen, welche die Diffusion von Zink in die Dickenabmessung des oder der Einführungsdrähte (7) favorisiert.

12. Vorrichtung nach Anspruch 11, dadurch gekennzeichnet, daß die Mittel (11, 12, 13) zum Bewirken einer komplementären Wärmeenergiezuführung Mittel umfassen, um einen gesteuerten elektrischen Strom in dem Abschnitt (14) des Drahtes durchgehen zu lassen, der den Hohlraum (3) des Ofens (1) durchquert.

13. Vorrichtung nach einem der Ansprüche 11 oder 12, dadurch gekennzeichnet, daß sie am Eingang einer Funkenerosionsmaschine derart angeordnet ist, daß der Einführungsdraht (7) kontinuierlich stromaufwärts von der Bearbeitungszone durch eine Funkenerosion behandelt wird.
